## Europäisches Patentamt
## European Patent Office
## Office européen des brevets

(11) Veröffentlichungsnummer: **0 038 580**
A1

(12) **EUROPÄISCHE PATENTANMELDUNG**

(21) Anmeldenummer: **81200312.7**

(22) Anmeldetag: **20.03.81**

(51) Int. Cl.³: **H 03 J 5/02**
**H 04 B 1/40**

(30) Priorität: **22.04.80 CH 3082/80**

(43) Veröffentlichungstag der Anmeldung:
**28.10.81 Patentblatt 81/43**

(84) Benannte Vertragsstaaten:
**AT BE CH DE FR GB IT LI NL SE**

(71) Anmelder: **Autophon A.G.**
**Ziegelmattstrasse 1-15**
**CH-4500 Solothurn 3(CH)**

(72) Erfinder: **Mansour, Sami**
**Neue Bellacherstrasse 9B**
**CH-4513 Langendorf/SO(CH)**

(74) Vertreter: **Bovard, Fritz Albert et al,**
**Bovard & Cie Patentanwälte VSP Optingenstrasse 16**
**CH-3000 Bern 25(CH)**

(54) **Funkgerät mit einem programmierbaren Speicher zur Steuerung von Sende- und Empfangskanälen.**

(57) Funkgerät, in welchem Sende- und Empfangsfrequenz mit Hilfe eines digital auf verschiedene Teilungsverhältnisse einstellbaren Frequenzteilers (32) "synthetisch" erzeugt werden. Das Teilverhältnis dieses Frequenzteilers (32) wird dabei in digitaler Weise durch Steuerpotentiale festgelegt, welche von Ausgängen (33,34,35) eines ausschliesslich der Ablesung dienenden Speichers (62,63) an den Teiler angelegt werden. Die an den genannten Ausgängen (33,34,35) auftretenden Steuerpotentiale sind dabei durch auf die Adress-Eingänge (64,65) des Speichers einwirkende Einstellorgane (66,67) bestimmt. Ein Teil der Ausgänge (151...155) des Speichers ist nicht zur Steuerung der Sende- und der Empfangsfrequenz sondern auch zur Steuerung von Nebenfunktionen, wie Anzeige- und Ueberwachungslampen (51,52), Selektivruf (40) und Steuertönen (37,38,39) verwendet.

./...

EP 0 038 580 A1

- 1 -

Funkgerät mit einem programmierbaren Speicher zur Steuerung von Sende- und Empfangskanälen.

Die vorliegende Erfindung betrifft ein Funkgerät mit mindestens einem Sender und mindestens einem Ueberlagerungsempfänger. Empfänger und Sender sind dabei durch Einstellorgane auf mehrere Kanäle einstellbar und gegebenenfalls sperrbar. In diesem Funkgerät wird sowohl die Sendefrequenz als auch die Ueberlagerungsfrequenz auf bekannte "synthetische" Weise erzeugt. Dabei ist ein Oszillator vorhanden, dessen Frequenz durch eine an ihn angelegte Spannung steuerbar ist und dessen Ausgangssignal - gegebenenfalls nach Mischung mit weitern Signalen - zur Erzeugung des Sendesignals und des Ueberlagerungssignals dient. Die Steuerung der Frequenz des genannten Oszillators umfasst einen Frequenzteiler, dem eine von der genannten Frequenz abgeleitete Frequenz zwecks Unterteilung zugeführt wird und dessen Teilverhältnis durch an ihn angelegte Steuerpotentiale beeinflussbar ist. Die Steuerung umfasst ferner einen Phasenvergleichskreis, welcher die unterteilte Frequenz mit einer festen Frequenz vergleicht und dessen Ausgangssignal die Frequenz des genannten Oszillators in einer die Verminderung der Frequenzdifferenz der beiden verglichenen Signale bewirkenden Weise regelt. Als feste Frequenz wird dabei vorzugsweise der kleinstmögliche Abstand zwischen zwei Kanälen oder ein ganzzahliger Teil davon verwendet, so dass durch Wahl des Teilungsverhältnisses die Frequenz des genannten Oszillators auf

- 2 -

verschiedene, untereinander den genannten Kanalabstand
oder ein Mehrfaches davon aufweisende Frequenzen gesteuert werden kann.

Im Funkgerät, auf welches sich die vorliegende Erfindung
bezieht, ist das für die Sende- und Empfangsfrequenz massgebende Teilungsverhältnis durch einen programmierbaren,
ausschliesslich für die Ablesung von Daten geeigneten
Speicher (PROM) gesteuert. Dieser Speicher gibt dabei aufgrund von an ihn angelegten Adressen Steuerpotentiale ab,
wobei diese Adressen den Stellungen der genannten Einstellorgane  entsprechen und die Steuerpotentiale zur Steuerung
des Frequenzteilers dienen.
In einem Funkgerät der beschriebenen Art können somit
Sende- und Empfangskanäle mit Hilfe des im Speicher gespeicherten Programms den Stellungen der Einstellorgane
beliebig zugeordnet werden, wobei für Senden und Empfangen die gleiche Frequenz (Simplex) oder eine verschiedene Frequenz (Semi-Duplex oder Duplex) gewählt werden
kann. Sofern nicht sämtlichen Stellungen der Einstellorgane ein Kanal entspricht, können die vom Speicher abgegebenen Potentiale auch zur Freigabe und Sperrung von
Sender und Empfänger dienen.

Es ist allgemein bekannt, in Funkgeräten der beschriebenen Art Organe zur Ausübung von Nebenfunktionen anzuordnen, wobei als Nebenfunktionen beispielsweise die Sendung
und der Empfang von Ton-Selektivruf, die Sendung von Quittungs-, Ueberwachungs- und Kennsignalen und die Erzeugung
und Auswertung von unterhalb des Sprachbandes liegenden
Steuersignalen verstanden ist. Bei einem derartigen Funkgerät kann ferner das Bedürfnis bestehen, die verschiedenen Nebenfunktionen nur je zusammen mit bestimmten Kanälen einzuschalten, und es kann sich als wünschbar

- 3 -

erweisen, mit Lampen anzuzeigen, ob zum Beispiel die gewählte Lage der Einstellorgane einem für das betreffende Gerät zugelassenen Kanal entspricht oder ob ein besonderer Kanal oder andere Nebenfunktionen ein- oder ausgeschaltet sind.

Es ist naheliegend, diese verschiedenen Nebenfunktionen mit Einzelschaltern oder mit einem Betriebsartenschalter ein-, aus- und umzuschalten. Die Bedienung eines solchen Gerätes ist jedoch unübersichtlich, und es können leicht Fehler unterlaufen.

Die vorliegende Erfindung ermöglicht nun, die verschiedenen zusammen mit der Kanalwahl notwendigen Ein-, Aus- und Umschaltungen für jedes Funkgerät individuell vorzuprogrammieren und eine sehr einfache Bedienung mit zwangsläufigen Abhängigkeiten zu ermöglichen, ohne dass im allgemeinen gegenüber den naheliegenden Lösungen ein Mehraufwand notwendig ist. Die Erfindung betrifft ein Funkgerät der eingangs beschriebenen Art, in welchem die zuletzt erwähnten Vorteile dadurch erreicht werden, dass ein Speicher verwendet ist, bei welchem die Zahl der Speicherplätze und der Ausgänge die für die Steuerung des Frequenzteilers und gegebenenfalls für die Sperrung und Freigabe des Senders und des Empfängers notwendige Zahl übersteigt und dass die in diesem Sinne überzähligen Ausgänge mindestens zum Teil für die Steuerung von Nebenfunktionen verwendet sind. Beispiele solcher Nebenfunktionen sind in den abhängigen Ansprüchen aufgeführt.

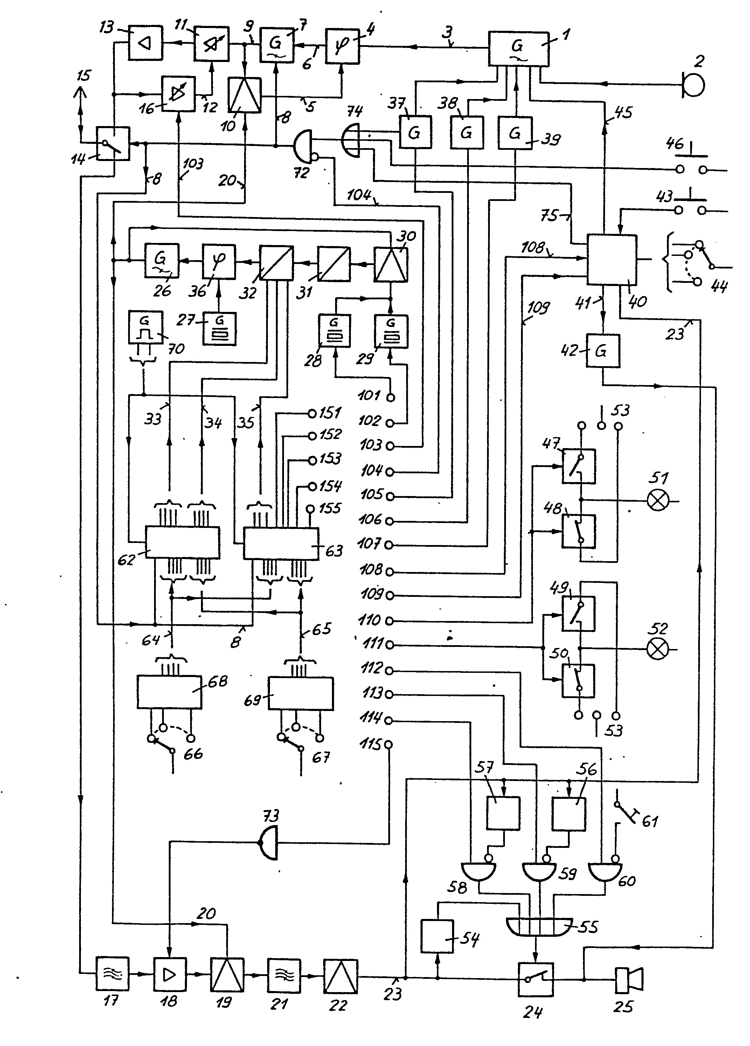

Die Erfindung wird nun anhand eines Ausführungsbeispiels erklärt. Die Figur zeigt das Schaltschema dieses Beispiels, wobei Baugruppen, welche nicht direkt mit der Erfindung zusammenhängen, sehr stark vereinfacht dargestellt sind.

- 4 -

Ein Teil von Baugruppen, insbesondere Filter und Zwischenverstärker, deren Kenntnis für das grundsätzliche Verständnis des Beispiels nicht notwendig ist, sind weggelassen, und gelegentlich sind verschiedene, in Wirklichkeit getrennte Baugruppen als ein einziger Block dargestellt.

In diesem Beispiel sind mehrere Nebenfunktionen beschrieben, welche wahlweise vom Speicher aus ein-, aus- oder umschaltbar sind. In Wirklichkeit wird es kaum vorkommen, dass an einem Funkgerät gleichzeitig alle diese Möglichkeiten vorgesehen sind, und auch im beschriebenen Beispiel wäre es nicht möglich, alle dargestellten Nebenfunktionen unabhängig voneinander zu steuern. Die gewählte Art der Darstellung ermöglicht es jedoch, die Beschreibung auf ein einziges Ausführungsbeispiel zu beschränken.

Das Ausführungsbeispiel betrifft ein Funkgerät für abwechslungsweise Sendung und Empfang frequenzmodulierter Signale im Bereich zwischen 138 und 174 MHz bei einem kleinstmöglichen Kanalabstand von 12,5, 20 oder 25 kHz. Die Schaltbreite, d.h. der Abstand zwischen der höchsten und der niedrigsten Frequenz, auf welche ein bestimmtes Gerät betriebsmässig einstellbar ist, beträgt 6 MHz, und es sind sowohl Kanäle für Sendung und Empfang auf der gleichen als auch solche für Sendung und Empfang auf verschiedenen Frequenzen wählbar. Die Kanäle sind an zwei Einstellorganen mit je 10 Stellungen einstellbar, wodurch sich 100 Einstellmöglichkeiten ergeben. Weitere Eigenschaften des Ausführungsbeispiels werden später beschrieben.

Im obern Teil der Figur ist das Schema des Sendeteils, im untern Teil das Schema des Empfängerteils dargestellt.

- 5 -

Dazwischen liegen die Stromkreise der als "Frequenzaufbereitung" bezeichneten Schaltungsanordnung, welche ein Signal liefert, dessen Frequenz genau einstellbar ist und von welchem die Sende- und die Empfangsfrequenz abgeleitet werden. Weitere im Mittelteil der Figur dargestellte Stromkreise betreffen Anordnungen für Nebenfunktionen.

Der Sendeteil umfasst einen ersten spannungsgesteuerten Oszillator 1, dessen Mittelfrequenz der Zwischenfrequenz des Empfängers entspricht, wobei diese Frequenz durch vom Mikrofon 2 abgegebene und andere später erklärte Signale beeinflussbar ist. Das auf diese Weise erzeugte frequenzmodulierte Signal gelangt über die Verbindung 3 nach einem Phasenvergleicher 4, wo seine Phase mit derjenigen des über die Verbindung 5 eintreffenden Signals verglichen wird. Eine aufgrund dieses Vergleichs erzeugte Regelspannung regelt über die Verbindung 6 einen zweiten spannungsgesteuerten Oszillator 7, welcher über die Verbindung 8 ein- und ausschaltbar ist, d.h. getastet werden kann. Das über die Verbindung 5 zugeführte Signal stammt aus der Mischstufe 10, in welchem das Ausgangssignal des genannten zweiten Oszillators 7 mit dem von der Frequenzaufbereitung über die Verbindung 20 zugeführten Signal gemischt wird. Das vom zweiten Oszillator 7 über die Verbindung 9 abgegebene Signal gelangt ausser an die Mischstufe 10 an den Regelverstärker 11, dessen Verstärkungsgrad über die Verbindung 12 geregelt wird. Das Ausgangssignal des Regelverstärkers 11 gelangt über den Endverstärker 13 an die Antennenumschaltung 14, an welche die Antenne 15 angeschlossen ist. Ein kleiner Teil des Ausgangssignals des Endverstärkers 13 wird vom Verstärker 16 verarbeitet, dessen Verstärkungsgrad über die Verbindung 103 auf eine von zwei Stufen einstellbar ist.

- 6 -

Der Sender wird in erster Linie von der Sendetaste 46 aus über das ODER-Tor 74 und das UND-Tor 72 getastet, wobei auch die Antennenumschaltung 14 gesteuert und weitere, später erklärte Schaltvorgänge ausgelöst werden. Ueber das Tor 74 kann der Sender noch über weitere Stromkreise getastet werden.

Der Empfangsteil weist ein erstes Bandfilter 17 auf, dem von der Antennenumschaltung 14 ein Eingangssignal zugeführt wird und dessen Ausgang mit dem Zwischenverstärker 18 verbunden ist. Dieser Zwischenverstärker und damit der Empfänger ist vom Schaltpunkt 115 aus über den Inverter 73 ausschaltbar. In der Mischstufe 19 wird das Eingangssignal mit dem über die Verbindung 20 von der Frequenzaufbereitung her zugeführten Ueberlagerungssignal gemischt. Mit Hilfe eines Zwischenfrequenz-Bandfilters 21 und eines Diskriminators 22 wird auf der Verbindung 23 ein Niederfrequenz-Signal erzeugt, welches über den elektronischen Schalter 24 dem Lautsprecher 25 zugeführt wird. Ein Rauschdetektor 54 öffnet über das ODER-Tor 55 den Schalter 24, wenn keine Gegenstation empfangen wird und daher am Empfängerausgang Rauschen auftritt. Weitere Möglichkeiten, den Lautsprecher vom Empfängerausgang abzutrennen werden später beschrieben.

Die Frequenzaufbereitung erzeugt das über die Verbindung 20 einerseits der Mischstufe 19 des Empfängers und andererseits der Mischstufe 10 des Senders zugeführte. Ueberlagerungssignal mit einem spannungsgesteuerten Oszillator 26. Die Frequenz dieses Ueberlagerungssignals wird von zwei stabilen Generatoren abgeleitet und ist auf digitale Weise einstellbar.

Das vom spannungsgesteuerten Oszillator 26 abgegebene Signal wird in der Mischstufe 30 mit dem Ausgangssignal eines der stabilen Oszillatoren 28 oder 29 gemischt, und die durch das Mischen entstehende Differenzfrequenz wird einem ersten, ein Teilungsverhältnis von vier aufweisenden Frequenzteiler 31 zugeführt. In einem zweiten, ein zwischen 200 und 799 liegendes Teilungsverhältnis aufweisenden Frequenzteiler 32 wird die Frequenz nochmals geteilt, wobei das Verhältnis je über die vier Verbindungen 33 und 34 und die drei Verbindungen 35 festgelegt wird. In der Phasenvergleichsstufe 36 wird das die unterteilte Frequenz aufweisende Signal mit dem Signal aus dem stabilen Oszillator 27 verglichen, und mit dem von dieser Stufe abgegebenen Regelsignal wird die Frequenz des Oszillators 26 geregelt.

Das Funkgerät weist ausser der beschriebenen Grundausrüstung, welche für Sendung und Empfang unabdingbar ist, weitere Einrichtungen auf, die nach Bedarf einsetzbar sind. Solche weitern, Nebenfunktionen ausübende Einrichtungen sind beispielsweise die Erzeuger 38 und 39 für zwei verschiedene Steuertöne, welche dem ausgesendeten Sprechsignal unterlagert werden (Tonsquelch). Eine weitere derartige Einrichtung ist ein Erzeuger 37 für ein Ueberwachungssignal, welches, während das Funkgerät auf Empfang geschaltet ist, in Abständen von ungefähr einer Sekunde den Empfang unterbricht und das Aussenden eines kurzen Tons veranlasst, wodurch an einer auf Empfang stehenden Gegenstation die Sendebereitschaft der das Ueberwachungssignal abgebenden Station und das Vorhandensein einer diesbezüglichen Verbindung feststellbar ist. Die drei Erzeuger 37, 38 und 39 geben die Tonsignale, entsprechend dem Mikrofon 2, an den ersten spannungsgesteuerten Oszillator 1 ab, und der Erzeuger 37 tastet über das ODER-Tor 74 den Sender.

Eine weitere, Nebenfunktionen ausübende Schaltungsanordnung ist die Einrichtung 40 für Tonselektivruf. Diese Einrichtung kann Folgen von fünf Tönen sowohl auswerten als auch erzeugen. Sofern ihr über die Verbindung 23 eine das betreffende Gerät kennzeichnende Tonfolge zugeführt wird, veranlasst sie über die Verbindung 41 den Tonerzeuger 42, an den Lautsprecher 25 ein Aufmerksamkeitszeichen abzugeben. Sie kann daneben, sofern diese Arbeitsweise über die Verbindung 109 eingeschaltet ist, parallel zur Abgabe des Aufmerksamkeitszeichens eine das betreffende Gerät kennzeichnende Tonfolge als Quittungssignal über die Verbindung 45 an den Sender abgeben und über die Verbindung 75 den Sender tasten. Sie kann ferner dieses Quittungssignal als Kennungssignal immer dann aussenden, wenn sie über die Verbindung 108 einen Steuerbefehl erhält. Sofern die Taste 43 betätigt wird, gibt die Einrichtung 40 über die Verbindung 45 eine Tonfolge ab, welche der Einstellung am Ruf-Wahlschalter 44 entspricht und welche dem Anruf eines bestimmten, mit dem Wahlschalter eingestellten Gerätes dient. Der Sender wird dabei über die Verbindung 75 getastet.

Weitere, Nebenfunktionen ausübende Einrichtungen sind die beiden Ueberwachungslampen 51 und 52, für welche vorzugsweise Leuchtdioden verwendet sind und welche durch die elektronischen Schalter 47...50 ein- und ausschaltbar sind. Die Schalter sind dabei von den Schaltpunkten 110 bzw. 111 aus gesteuert, und an den Rangierpunkten 53 kann durch Einlegen von Brücken gewählt werden, ob die Lampen durch das Steuerpotential ein- oder ausgeschaltet werden sollen.

- 9 -

Ueber den Schaltpunkt 112, das UND-Tor 60 und das ODER-Tor 55 kann der Lautsprecher 25 vom Empfängerausgang abgetrennt werden. Mit dem Handschalter 61, welcher über einen invertierenden Eingang auf das Tor 60 einwirkt, kann diese Sperrung wiederum aufgehoben werden.

Die beiden, ebenfalls Nebenfunktionen ausübenden Steuerton-Empfänger 56 und 57, denen über die Verbindung 23 das Ausgangssignal des Empfängers zugeführt wird, erzeugen je aufgrund des Empfangs eines bestimmten, dem Sprechsignal unterlagerten Steuertons ein Ausgangssignal, welches je an den invertierenden Eingang eines der beiden UND-Tore 58 und 59 gelegt ist. Die Ausgänge der beiden Tore 58 und 59 wirken über das Oder-Tor 55 auf den bereits erwähnten elektronischen Schalter 24 ein.

Mit 62 und 63 sind die beiden Teile eines programmierbaren, ausschliesslich zur Ablesung bestimmten Speichers (PROM) bezeichnet. Jeder dieser Teile, für welche vorzugsweise ein löschbarer Typ (EPROM) verwendet ist, weist je 4096 Speicherplätze auf, welche derart geordnet sind, dass an je $2^9=512$ Adressen je acht Werte gespeichert sind. Jeder Teilspeicher weist somit acht Ausgänge zur Ausgabe der gespeicherten Daten und neun Eingänge auf, über welche die Adressen binär kodiert ansteuerbar sind. Am Speicherteil 62 sind diese Ausgänge in zwei Gruppen 33 und 34 zu je vier Ausgängen unterteilt, wobei mit jeder Gruppe in binärer Weise die Ziffern 0...9 darstellbar sind. Am Speicherteil 63 ist von den acht Ausgängen eine Gruppe 35 mit drei Ausgängen abgetrennt, mit welcher in binärer Weise die Ziffern 0...7 darstellbar sind, während die übrigen fünf Ausgänge 151...155 in später beschriebener Weise voneinander unabhängige Steuerbefehle ausgeben.

Von den neun Adressen-Eingängen ist der eine an die Verbindung 8 gelegt, während die andern in zwei Gruppen 64 und 65 von je vier, eine Dezimalziffer darstellenden Eingängen zusammengefasst sind. Ueber jede dieser Gruppen wird die Stellung eines der Kanal-Einstellorgane 66 und 67 übertragen, welche je zehn Stellungen aufweisen. Die eingestellten, dem Zehner und dem Einer der gewünschten Kanalnummer entsprechenden Werte werden dabei mit Hilfe der beiden Kodier-Matritzen 68 und 69 je in binär kodierte Ziffern umgesetzt. Die Eingänge der beiden Teil-Speicher 62 und 63 sind parallel geschaltet. Auf die beschriebene Weise sind von den 512 vorhandenen Adressen deren zweihundert ausgenützt.

Die hier verwendeten programmierbaren Speicher weisen den Ausgängen einzeln zugeordnete bistabile Stromkreise auf, welche einen bestimmten binären Zustand des betreffenden Ausgangs festhalten. Um diese Zustände aufgrund der Aenderung der angelegten Adresse zu ändern ist es notwendig, an den Speicher ausser der geänderten Adresse zwei aufeinanderfolgende Aktivierungsimpulse (Strobe) anzulegen. Um nun eine unverzügliche Anpassung des Status der Ausgänge an eine Aenderung der Adressierung an den Eingängen zu ermöglichen, gibt ein Impulsgenerator 70 im Rhythmus von 25 kHz Impulspaare zur Aktivierung des Speichers ab. Da während des Sendezustandes des Gerätes an den Schaltern 66 und 67 keine Aenderung der Einstellung vorgenommen wird, kann während dieses Zustandes auf den Betrieb des Generators 70 verzichtet werden. Damit entfallen auch Störungen durch Oberwellen dieses Generators, welche auf den Steuereingang des Oszillators 26 gelangen und damit Pendelungen der Sendefrequenz um ihren Sollwert erzeugen könnten.

Wie bereits erwähnt wurde, ist die Frequenz des von der Frequenzaufbereitung über die Verbindung 20 abgegebenen Signals für die Sende- und für die Empfangsfrequenz bestimmend. Dieses Signal wird vom spannungsgesteuerten Oszillator 26 erzeugt und liegt, sofern ein Frequenzbereich von 138...178 MHz und eine Zwischenfrequenz von 21,4 MHz

- 11 -

vorausgesetzt wird, zwischen 116,6 und 156,6 MHz. Die von den Oszillatoren 28 und 29 zu liefernde Frequenz richtet sich nach der Lage des Schaltbandes innerhalb des gesamten Frequenzbereichs des Gerätes. Innerhalb dieses Schaltbandes, dessen Breite im vorliegenden Beispiel 6 MHz beträgt, können mit den Einstellorganen 66 und 67 die Sende- und Empfangsfrequenzen (Kanäle) gewählt werden, mit denen das Gerät arbeiten soll. Für die folgenden Erklärungen der Zusammenhänge bei der Erzeugung von Frequenzen wird als Beispiel ein zwischen 147 und 153 MHz liegendes Schaltband angenommen. Daraus ergeben sich für das Signal auf den Verbindungen 20 Werte zwischen 125,6 und 131,6 MHz, und die Frequenz des Oszillators 28 wird auf 121,6 MHz festgelegt. Für das aus der Mischung im Mischer 30 entstehende Differenzsignal ergeben sich dann Werte zwischen 4 und 10 MHz. Da die Frequenz dieses Signals im Frequenzteiler 31 durch vier geteilt wird, ist am Eingang des Frequenzteilers 32 eine zwischen 1 und 2,5 MHz liegende Frequenz vorhanden. Die Frequenz des vom Oszillator 27 abgegebenen Signals ist ein Viertel oder ein Achtel des für das betreffende Gerät gewählten kleinstmöglichen Kanalabstandes und beträgt somit 3,125 kHz für 12,5 und 25 kHz Kanalabstand und 5 kHz für 20 kHz Abstand.

Sofern nun am Ausgang des Frequenzteilers 32 ein Signal mit einer Frequenz von 3,125 kHz entstehen soll, entspricht jedem zwischen 320 und 800 liegenden Teilungsverhältnis dieses Frequenzteilers eine bestimmte, zwischen 1 und 2,5 MHz liegende Frequenz, die an seinen Eingang angelegt werden muss. Für ein Ausgangssignal von 5 kHz liegt das Teilungsverhältnis zwischen 200 und 500. Dieses Ausgangssignal des Frequenzteilers wird im Phasenvergleicher 36 mit der stabilen Frequenz des Oszillators 27 verglichen und regelt den Oszillator 26 auf eine Frequenz,

- 12 -

welche am Eingang des Frequenzteilers 32 die genannte bestimmte Frequenz erzeugt. Jedem gewählten Teilungsverhältnis entspricht somit eine bestimmte, vom Oszillator 26 erzeugte Frequenz. Die erzeugbaren Frequenzen weisen dabei Abstände auf, welche dem kleinsten möglichen Kanalabstand (bei 12,5 und 20 kHz Abstand) oder der Hälfte davon (bei 25 kHz Abstand) entsprechen.

Sofern für einen Teil der Sende- und Empfangsfrequenzen Werte festgesetzt sind, welche von andern Frequenzen einen besondern Abstand aufweisen, welcher nicht ein ganzzahliges Vielfaches des kleinstmöglichen Kanalabstandes ist, muss die der Mischstufe 30 zugeführte, der vom Oszillator 26 erzeugten Frequenz überlagerte Frequenz auf einen Wert festgesetzt werden, welcher gegenüber der durch den Oszillator 28 erzeugten Frequenz verschoben ist. Der Oszillator 29 dient zur Erzeugung einer solchen verschobenen Frequenz, wobei die notwendige Verschiebung vom genannten besondern Abstand abhängt. Mit Hilfe des Oszillators 29 ist die Erzeugung einer zweiten Frequenzreihe möglich, bei welcher jedoch die Kanalabstände wiederum ganzzahlige Vielfache eines Grundwertes sind. Für weitere unregelmässige Kanalabstände müssten zu den Oszillatoren 28 und 29 zusätzliche Oszillatoren angeordnet werden.

Das über die Verbindung 20 von der Frequenzaufbereitung abgegebene, eine zwischen 125,6 und 131,6 MHz liegende Frequenz aufweisende Signal wird im Mischer 10 des Senders mit dem durch den Oszillator 7 erzeugten, die Sendefrequenz aufweisenden Signal (Verbindung 9) gemischt. Die über die Verbindung 5 am Ausgang des Mischers abgegebene Differenzfrequenz weist nur dann den Sollwert von 21,4 MHz auf, wenn die Sendefrequenz 21,4 MHz über derjenigen der Frequenzaufbereitung und somit zwischen

- 13 -

147 und 153 MHz liegt. Der Oszillator 7 wird nun mit
Hilfe des Phasenvergleichers 4 derart geregelt, dass die
genannte Differenzfrequenz der vom Oszillator 1 erzeugten, 21,4 MHz betragenden Frequenz entspricht. Die Modulation der Frequenz des Oszillators 1 wird auf diese
Weise auch auf die Sendefrequenz übertragen. Mit Hilfe
des Verstärkers 16 regelt der Regelverstärker 11 die an
die Antenne 15 abgegebene Leistung auf einen gleichbleibenden, durch den Verstärkungsgrad des Verstärkers 16
bestimmten Wert.

Die Zwischenfrequenz, für welche das Bandfilter 21 ausgelegt ist, beträgt 21,4 MHz und somit gleichviel wie
die Frequenz des Oszillators 1 im Sender. Einer bestimmten, von der Frequenzaufbereitung über die Verbindung 20
abgegebenen Frequenz entspricht somit die gleiche Sende-
und Empfangsfrequenz.

Der aus den beiden Teilspeichern 62 und 63 bestehende
Speicher ist derart programmiert, dass zu jeder Stellung
der Einstellorgane 66 und 67, die einem für Sendung und/
oder Empfang bestimmten Kanal entspricht, das Teilungsverhältnis gespeichert ist, auf welches der Frequenzteiler 32 über die Verbindungen 33, 34 und 35 gesteuert
werden soll. Ueber den Eingang 8 wird dem Speicher das
Sendekriterium (Tastkriterium) zugeführt, wo es wie die
von den Einstellorganen beeinflussten Eingänge 33, 34
und 35 als Adresskriterium dient. Jeder Stellungskombination der beiden Einstellorgane sind im Speicher zwei
Adressen zugeteilt, wovon die eine im Empfangsfall, die
andere im Sendefall wirksam ist. Sofern bei einer bestimmten Stellung der Einstellorgane auf derselben Frequenz
gesendet und empfangen werden soll (Simplex-Verkehr),
muss der Speicher jeweils an zwei zusammengehörenden

- 14 -

Adressen in bezug auf das Teilungsverhältnis gleich
programmiert sein; bei verschiedenen Frequenzen (Semi-
Duplex) dagegen verschieden. Soll immer nur auf der
gleichen Frequenz gesendet und empfangen werden, kann
die Verbindung 8 unterbrochen und damit die Zahl der
gespeicherten Daten halbiert werden.

Der Teilspeicher 63 ist nun derart programmierbar, dass
an seinen fünf nicht für die Steuerung des Frequenzteilers 32 benötigten Ausgängen für jede über die Eingänge
eingegebene, einer Stellungskombination der Einstellorgane 66 und 67 entsprechende Adresse eine beliebige Kombination von Steuerpotentialen entsteht. Diese Steuerpotentiale können dann für beliebige in der Folge beschriebene Steuerzwecke anstelle von besondern handbetätigten oder mechanisch mit den Einstellorganen 66 und
67 gekoppelten Schaltern verwendet werden. Zu diesem
Zweck sind die an den genannten Ausgängen angebrachten
Schaltpunkte 151...155 wahlweise mit je einem oder mehreren der 15 Schaltpunkte 101...115 verbindbar, wodurch
mit den Einstellorganen 66 und 67 ausser der Wahl der
Frequenzen die bereits erwähnten Nebenfunktionen zur
Wirkung gebracht werden können. Einzelne Schaltpunkte
101...115 können auch, sofern die dort angeschlossene
Steuerung nicht von der Stellung der Wahlschalter 66
und 67 abhängig sein soll, in nicht dargestellter Weise
mit festen Potentialen verbunden werden.

Die beiden Schaltpunkte 101 und 102 sind - im Gegensatz
zu den Schaltpunkten 103...115 - der Steuerung der Sende- und Empfangsfrequenz zugeordnet. Sofern der Oszillator 28 für die Erzeugung aller benötigten Frequenzen
genügt, kann auf die Schaltpunkte 101 und 102 verzichtet werden. Sofern dagegen (gemäss den früheren Darlegungen) ein Oszillator 29 notwendig ist, können über die Schaltpunkte 101 und 102 die beiden Oszillatoren wahlweise in Betrieb gesetzt werden.

Ueber den Schaltpunkt 103 kann der Verstärker 16 derart
beeinflusst werden, dass der Regelverstärker 11 die Sendeleistung ändert. Durch Beeinflussung dieses Schaltpunktes von einem Ausgang des Speichers aus ist es somit
möglich, auf den verschiedenen Kanälen mit verschiedener
Sendeleistung zu senden.

Ueber den Schaltpunkt 104 und das UND-TOR 72 kann die
Verbindung 8 gesperrt und damit die Tastung des Senders
verhindert werden. Durch Beeinflussung dieses Schaltpunktes ist es somit möglich, in bestimmten Stellungskombinationen der Einstellorgane ausschliesslich den
Empfänger zu betreiben.

Ueber den Schaltpunkt 105 kann der Erzeuger 37 des Ueberwachungssignals eingeschaltet werden. Sofern von dieser
Möglichkeit Gebrauch gemacht wird, muss bei der Programmierung des Speichers darauf geachtet werden, dass diese
Einschaltung nur während des Empfangs erfolgt.

Ueber die Schaltpunkte 106 und 107 kann wahlweise einer
der Erzeuger 38 oder 39 eines Steuertons in Betrieb gesetzt werden. Sofern von dieser Möglichkeit Gebrauch gemacht wird muss bei der Programmierung des Senders darauf
geachtet werden, dass diese Einschaltung nur während der
Sendung erfolgt.

Beim jeweiligen Anlegen von Steuerpotential an den Schaltpunkt 108 wird die Selektivrufeinrichtung 40 veranlasst,
das Kennungssignal des betreffenden Gerätes abzugeben
und den Sender zu tasten. Durch Beeinflussung dieses

- 16 -

Schaltpunktes von einem Ausgang des Speichers aus ist es somit möglich, dass bei der Einschaltung bestimmter Kanäle das Funkgerät jeweils beim Uebergang von Empfang auf Sendung sein Kennsignal abgibt. Bei der Programmierung des Speichers muss dabei darauf geachtet werden, dass der Schaltpunkt 108 nur bei Sendung ein Steuerpotential erhält.

Ueber den Schaltpunkt 109 kann die Selektivrufeinrichtung 40 derart gesteuert werden, dass sie ein Quittungssignal abgibt, sobald ihr eine Tonfolge zugeführt wird, welche dem Anrufsignal für das betreffende Gerät entspricht.

Mit den über die Schaltpunkte 110 und 111 ein- und ausschaltbaren Lampen können beispielsweise die Einstellung des Gerätes auf einen bestimmten Kanal, die Einstellung auf einen für Sendung gesperrten Kanal, eine Einstellung, welche keinem Kanal entspricht oder die Ein- oder Ausschaltung des Selektivrufs, des Steuertons oder des Ueberwachungssignals angezeigt werden.

Ueber den Schaltpunkt 112 kann die Einschaltung des Lautsprechers 25 von der Betätigung des Handschalters 61 abhängig gemacht werden. Diese Anordnung wird im Zusammenhang mit dem Selektivruf benützt, indem beim Vorhandensein eines Steuerpotentials am Schaltpunkt 112 der Lautsprecher normalerweise ausgeschaltet ist und erst dann von Hand eingeschaltet wird, nachdem das Gerät selektiv angerufen wurde.

Ueber die Schaltpunkte 113 und 114 kann beim Anlegen entsprechender Steuerpotentiale der Schalter 24 derart gesteuert werden, dass der Lautsprecher 25 nur dann mit dem Empfängerausgang verbunden wird, wenn gleichzeitig ein der Abstimmung des Steuerton-Empfängers 56 oder 57 entsprechender Steuerton empfangen wird.

- 17 -

Ueber den Schaltpunkt 115 kann der Empfänger ausgeschaltet werden. Dies ist in Stellungskombinationen der Einstellorgane, in denen nichts empfangen werden soll, notwendig, da auch bei fehlender Steuerung des Frequenzteilers die Oszillatoren auf irgend einer unerwünschten Frequenz arbeiten und der Empfänger auf einer entsprechenden Frequenz empfangen würde, sofern er nicht ausgeschaltet würde. Auf den Schaltpunkt 115 könnte verzichtet werden, wenn in nicht dargestellter Weise mittels Toren dafür gesorgt wäre, dass der Empfänger nur dann eingeschaltet wäre, wenn der Speicher über seine Ausgänge irgend ein Teilungsverhältnis steuern würde.

Die verschiedenen in bezug auf die Schaltpunkte 101...115 beschriebenen Funktionen können nun, sofern eine entsprechende Programmierung des Speichers 63 vorausgesetzt wird, in Abhängigkeit von den verschiedenen Stellungskombinationen der Einstellorgane 66 und 67 zur Wirkung gebracht werden, wenn die Schaltpunkte 151...155 in passender Weise mit den Schaltpunkten 101...115 verbunden werden. Neben der Wahl der Frequenzen für Senden und Empfangen können infolgedessen mit Hilfe der genannten Organe auch nicht mit der Frequenzwahl im Zusammenhang stehende Nebenfunktionen gesteuert werden.

Sofern bei einem Gerät die Zahl der möglichen Stellungskombinationen der Einstellorgane die Zahl der einzustellenden Kanäle übersteigt und die Nebenfunktionen nicht an bestimmte Kanäle gebunden sind, ist es möglich, mit verschiedenen Kombinationen jeweils den gleichen Kanal einzuschalten, dabei jedoch die eingeschalteten Nebenfunktionen zu ändern. Bei einer solchen Anordnung, in welcher grundsätzlich Nebenfunktionen unabhängig von den Kanälen geschaltet werden, kann somit trotzdem auf besondere Bedienungsorgane für die Nebenfunktionen verzichtet werden.

Es ist gegebenenfalls möglich, die Schaltpunkte 151...
155 je mit mehr als einem der Schaltpunkte 101...115 zu
verbinden, so dass mehr als fünf Nebenfunktionen durch
den Speicher 63 gesteuert werden können. Dies gilt insbesondere für die Lampen, welche je mit der Steuerung
der Nebenfunktionen, deren Ein- oder Ausschaltung sie
anzeigen sollen, parallel geschaltet werden können. Auch
die Einschaltung der Abgabe eines Quittungssignals zusammen mit der Sperrung des Lautsprechers oder die Einschaltung sowohl der Aussendung als auch der Auswertung
eines Steuertones kann je vom gleichen Ausgang des Speichers aus erfolgen.

Unter der Voraussetzung eines kleinsten Kanalabstandes
von 25 kHz kann, sofern die Frequenz des Oszillators 27
gegenüber den vorher angegebenen Werten verdoppelt wird,
das grösste notwendige Teilverhältnis des Teilers 32 auf
die Hälfte, d.h. auf 400 vermindert werden, wodurch nur
noch zwei Verbindungen 35 notwendig sind und somit für
die Steuerung von Nebenfunktionen ein sechster Ausgang
des Speichers 63 zur Verfügung steht.

Es wäre auch möglich, den Teilspeichern 62 und 63 einen
weitern Teilspeicher beizufügen, welcher ausschliesslich
zur Steuerung von Nebenfunktionen bestimmt wäre, oder
es könnten weitere in der Figur nicht dargestellte Funktionen durch den Speicher gesteuert werden. So könnte
beispielsweise in einem Gerät, das mit einer Antennenweiche ausgerüstet ist und eine Betriebsart, welche
gleichzeitiges Senden und Empfangen (Duplex) erlaubt
auch eine Umgehungsschaltung für die Antennenweiche angeordnet sein, welche in ihrem aktiven Zustand eine Betriebsart für abwechslungsweises Senden und Empfangen auf
der gleichen Frequenz (Simplex) ermöglicht, wobei mit Hilfe der Einstellorgane nicht nur die Kanalfrequenzen sondern auch die Betriebsart gewählt werden könnte. Sofern Bandfilter verwendet würden, deren Mittelfrequenz verstellbar wäre, könnte durch den Speicher auch diese Funktion gesteuert werden, wodurch die Schaltbreite des Gerätes über die durch feste Filter beschränkten Werte hinaus erweitert werden könnte.

Die Erfindung ist natürlich auch sonst nicht an das Ausführungsbeispiel gebunden. Insbesondere die Frequenzaufbereitung und die Art der Mischung im Sender könnten auch auf andere bekannte Arten gelöst werden. Ebensowenig ist die Erfindung auf Funkgeräte mit dem angegebenen Frequenzbereich, der angegebenen Schaltbreite und der angegebenen Modulationsart beschränkt. Die gezeigten Schaltpunkte 101...115 bzw. 151...155 könnten wegfallen, wenn die Zahl der zu steuernden Nebenfunktionen die Zahl der für diesen Zweck bestimmten Ausgänge am Speicher nicht überstiege. Es ist ferner für die Erfindung unerheblich, ob für den Speicher ein löschbarer (EPROM) oder ein nicht löschbarer (PROM) Typ verwendet ist und ob die Adressierung dezimal oder binär erfolgt.

- 1 -

Patentansprüche

1. Funkgerät mit mindestens einem Sender und mindestens einem Ueberlagerungsempfänger, welche je durch Einstellorgane (66,67) auf mehrere Kanäle einstellbar und gegebenenfalls sperrbar sind, enthaltend

- einen Oszillator (26), dessen Ausgangssignal - gegebenenfalls nach Mischung mit weitern Signalen - zur Erzeugung einerseits des Sendesignals und anderseits des Ueberlagerungssignals dient, wobei die Frequenz dieses Signalerzeugers durch eine an ihn angelegte Spannung steuerbar ist,

- einen Frequenzteiler (32), der eine von der Frequenz des Oszillators (26) abgeleitete Frequenz mit einem durch an ihn angelegte Steuerpotentiale (33,34,35) beeinflussbaren Teilungsverhältnis unterteilt

- einen Phasenvergleichskreis (36), welcher die unterteilte Frequenz mit einer festen Frequenz (27) vergleicht und dessen Ausgangssignal die Frequenz des Oszillators (26) in einer die Verminderung der Frequenzdifferenz der beiden verglichenen Signale bewirkenden Weise regelt

- einen programmierbaren, ausschliesslich für die Ablesung von Daten geeigneten Speicher (PROM)(62,63),

- 2 -

welcher aufgrund von daran angelegten, den Stellungen der genannten Einstellorgane entsprechenden Adressen (8,64,65) Steuerpotentiale abgibt, welche einerseits zur Steuerung des Frequenzteilers (32) und anderseits zur Sperrung und Freigabe (104,115) von Sender und Empfänger dienen,

dadurch gekennzeichnet, dass ein Speicher (62,63) verwendet ist, bei welchem die Zahl der Speicherplätze und der Ausgänge (33,34,35;151...155) die für die Steuerung des Frequenzteilers (32) und gegebenenfalls für die Sperrung und Freigabe (104, 115) des Senders und des Empfängers notwendige Zahl übersteigt und dass die in diesem Sinne überzähligen Ausgänge (151...155) mindestens zum Teil für die Steuerung von Nebenfunktionen verwendet sind.

2. Funkgerät nach dem Patentanspruch 1 mit mindestens einer Einrichtung (38,39) zur Erzeugung einer für die Unterlagerung der Sprachsignale bestimmten Steuersignals, dadurch gekennzeichnet, dass ein Teil der Speicherplätze und mindestens ein Ausgang (151...155) des Speichers (63) für die Steuerung (106,107) der Ein- und Ausschaltung der Steuersignale verwendet ist.

3. Funkgerät nach dem Patentanspruch 1 mit einem mit dem Sprechausgang (23) des Empfängers in Verbindung stehenden Lautsprecher (25) und einer Einrichtung (56,57) zur Auswertung eines einem empfangenen Sprachsignal unterlagerten Steuersignals, mit Schaltungsmitteln (58,59,55,24), welche die Verbindung des Sprechausgangs des Empfängers nur während des Empfangs eines Steuersignals mit dem Lautsprecher (25) verbinden, dadurch gekennzeichnet, dass ein Teil der Speicherplätze und mindestens ein Ausgang (151...155) des Speichers (63) verwendet ist, um die letztgenannten Schaltungsmittel (58,59,55,24) wahlweise (113,114) wirksam oder unwirksam werden zu lassen.

4. Funkgerät nach dem Patentanspruch 1 mit einem mit dem Sprechausgang des Empfängers in Verbindung stehenden Lautsprecher (25) und Schaltungsmitteln (60,55,24), welche die Verbindung des Sprechausgangs (23) des Empfängers in Abhängigkeit von der Stellung eines Handschalters (61) auftrennen oder belassen, dadurch gekennzeichnet, dass ein Teil der Speicherplätze und ein Ausgang (151...155) des Speichers (63) verwendet ist, um die letztgenannten Schaltungsmittel (60,55,24) wahlweise (112) wirksam oder unwirksam werden zu lassen.

- 4 -

5. Funkgerät nach dem Patentanspruch 1 mit Schaltungsmitteln (16,11), welche die vom Sender abgegebene Leistung beeinflussen, dadurch gekennzeichnet, dass ein Teil der Speicherplätze und ein Ausgang (151... 155) des Speichers (63) für die Steuerung (103) der genannten Schaltungsmittel (16,11) verwendet ist.

6. Funkgerät nach dem Patentanspruch 1 mit Schaltungsmitteln (37), welche während des Empfangszustandes des Geräts periodisch diesen Zustand kurzzeitig unterbrechen (74,72) und den Sender zur Aussendung eines Ueberwachungssignals veranlassen, dadurch gekennzeichnet, dass ein Teil der Speicherplätze und ein Ausgang (151...155) des Speichers (63) verwendet ist, um die letzgenannten Schaltungsmittel (37) wahlweise (105) wirksam oder unwirksam werden zu lassen.

7. Funkgerät nach dem Patentanspruch 1 mit einer Selektivrufeinrichtung (40), welche, nachdem sie ein zum Anruf der entsprechenden Station bestimmtes Signal empfangen hat, den Sender zur Aussendung eines Quittungssignals (45) veranlasst, dadurch gekennzeichnet, dass ein Teil der Speicherplätze und ein Ausgang (151...155) des Speichers (63) verwendet ist, um die Selektivrufeinrichtung (40) in einer Weise zu steuern, gemäss welcher sie wahlweise (109) die Aussendung des Quittungssignals (45) unterdrückt.

- 5 -

8. Funkgerät nach dem Patentanspruch 1 mit einem Kennsignalgeber (40), welcher jedesmal beim Sendebeginn
einem Modulationseingang des Senders eine das betreffende Gerät kennzeichnende Tonfrequenz-Folge
(45) zuführt, dadurch gekennzeichnet, dass ein Teil
der Speicherplätze und ein Ausgang (151...155) des
Speichers (63) verwendet ist, um den Kennsignalgeber
(40) zur Abgabe eines Signals zu veranlassen (108).


9. Funkgerät nach dem Patentanspruch 1, dadurch gekennzeichnet, dass ein Teil der Speicherplätze und mindestens ein Ausgang (151...155) des Speichers (63)
zur Steuerung von (110,111) Anzeigelampen (51,52) verwendet ist.

**Europäisches Patentamt**

## EUROPÄISCHER RECHERCHENBERICHT

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | IEEE TRANSACTIONS ON CONSUMER ELEC-TRONICS, Band CE-22, Nr. 3, August 1976, Seiten 214-219 New York, U.S.A. TICKLE: "A low cost solution to digital tuning of television receivers and citizen band transceivers" <br><br> * Seite 214, rechte Spalte, Zeilen 8-39; Figur 1; Seite 218, rechte Spalte, Zeilen 6-17 * <br><br> -- | 1,5 | H 03 J 5/02 <br> H 04 B 1/40 |
| | REVIEW OF THE ELECTRICAL COMMUNI-CATION LABORATORIES, Band 25, Nr. 11-12, November-Dezember 1977, Seiten 1231-1244 Tokyo, JP. SAKAMOTO et al.: "Mobile unit for 800 MHz band land, mobile telephone system" <br><br> * Seite 1231, rechte Spalte, Zeile 1 - Seite 1235, linke Spalte, Zeile 23; Figuren 1, 3,16 * <br><br> -- | 1-3,8 | **RECHERCHIERTE SACHGEBIETE (Int. Cl ³)** <br><br> H 03 J 5/02 <br> H 03 L 7/18 <br> H 04 B 1/40 <br> 1/50 <br> 1/44 <br> H 04 Q 7/00 |
| | DE - A - 2 838 104 (SONY) <br><br> * Seite 6, Zeile 4 - Seite 16, Zeile 12; Figuren 1,3 * <br><br> -- | 1 | |
| | THE BELL SYSTEM TECHNICAL JOURNAL, Band 58, Nr. 1, Januar 1979, Seiten 123-143 New York, U.S.A. FISHER: "A subscriber set for the the equipment test" <br><br> * Seite 126, Zeile 35 - Seite 132, Zeile 24; Figuren 4-6; Seite 137, Zeile 10 - Seite 139, Zeile 27; Figur 9 * | 1-3,5-8 | **KATEGORIE DER GENANNTEN DOKUMENTE** <br><br> X: von besonderer Bedeutung <br> A: technologischer Hintergrund <br> O: nichtschriftliche Offenbarung <br> P: Zwischenliteratur <br> T: der Erfindung zugrunde liegende Theorien oder Grundsätze <br> E: kollidierende Anmeldung <br> D: in der Anmeldung angeführtes Dokument <br> L: aus andern Gründen angeführtes Dokument <br> &: Mitglied der gleichen Patentfamilie. übereinstimmendes Dokument |

Der vorliegende Recherchenbericht wurde für alle Patentansprüche erstellt.

| Recherchenort | Abschlußdatum der Recherche | Prüfer |
|---|---|---|
| Den Haag | 14-07-1981 | DHONDT |

Europäisches
Patentamt

**EUROPÄISCHER RECHERCHENBERICHT**

| | EINSCHLÄGIGE DOKUMENTE | | | KLASSIFIKATION DER ANMELDUNG (Int.Cl. ³) |
|---|---|---|---|---|
| Kategorie | Kennzeichnung des Dokuments mit Angabe, soweit erforderlich, der maßgeblichen Teile | betrifft Anspruch | | |
| A | DE - A - 2 728 119 (SONY) <br><br> * Seite 4, Zeile 1 - Seite 17, Zeile 20; Figur 1 * <br><br> -- | 1,9 | | |
| A | 1977 ELECTRO CONFERENCE RECORD, 19.-21. April 1977, Seiten 1-8 herausgegeben von ELECTRO, El Segundo, (US) New York, U.S.A. MILLS: "New IC's for CB and personal communication", Nr. 4/3 <br><br> * Insgesamt * <br><br> ---- | 1 | | RECHERCHIERTE SACHGEBIETE (Int. Cl. ³) |

EPA Form 1503.2   06.78